# EUROPEAN PATENT APPLICATION

(11) **EP 1 972 438 A1**
(43) Date of publication of application: **24.09.2008**
(21) Application number: 08005129.5
(22) Date of filing: 19.03.2008
(51) Int. Cl.: B41C 1/10, B41N 3/03, G03F 7/00

(54) **Lithographic printing plate precursor and method of preparing lithographic printing plate**

(30) Priority: 20.03.2007 JP 2007072239
(71) Applicant: FUJIFILM Corporation, Minato-ku Tokyo (JP)
(72) Inventor: Aoshima, Keitaro, Haibara-gun, Shizuoka (JP); Sakasai, Yutaka, Haibara-gun, Shizuoka (JP)
(74) Representative: HOFFMANN EITLE

(57) **Abstract**

A lithographic printing plate precursor includes a support and an ink-receptive layer containing a microcapsule.

## Description

### FIELD OF THE INVENTION

The present invention relates to a lithographic printing plate precursor and a method of preparing a lithographic printing plate. More particularly, it relates to a lithographic printing plate precursor which is prevented from displacement of the image formed by an inkjet recording system and which can provide excellent printing aptitude and a method of preparing a lithographic printing plate.

### BACKGROUND OF THE INVENTION

In recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying the digitalized image information on highly converging radiation, for example, laser light and conducting scanning exposure of a lithographic printing plate precursor with the light thereby directly preparing a lithographic printing plate without using a lith film.

A CTP technique using an inkjet recording system is also known in addition to the CTP technique using a laser beam.

For instance, a plate making method comprising forming an image area on a support by an inkjet recording system using a photo-curable ink composition and exposing the image area to light to cure the ink composition is described in JP-A-5-204138 (the term "JP-A" as used herein means an "unexamined published Japanese patent application") (corresponding to U.S. Patent 5, 312, 654) and JP-A-4-69244. The inkjet recording system is a relatively high-speed image output system and the apparatus therefor is structurally simple because a complicated optical system is unnecessary. Since an image is formed with inkjet ink, there is no need to provide a coating film, for example, a photosensitive layer on a support on which the image is formed. Therefore, the cost for production of a lithographic printing plate can be reduced.

However, in the formation of image area on a support by the inkjet recording system, ink droplets impacted on the support are tend to course coalescence with each other so that a phenomenon so-called interference of ink droplet impact, for example, formation of openings in the solid portion occurs. When the interference of ink droplet impact occurs, in addition to the solid portion, a problem arises in that displacement of the image on a lithographic printing plate occurs and printing on a recording material can not be performed. The interference of ink droplet impact is described in Inkjet Kiroku niokeru Ink, Media and Printer no Kaihatsu Gijutsu, published by Technical Information Institute Co., Ltd..

Also, a method of preparing a lithographic printing plate comprising providing an image-forming layer containing a polymer particle on a support and forming an image on the image-forming layer with inkjet ink is described in JP-A-2003-94597 (corresponding to EP1266750A1). However, there is no description on the interference of ink droplet impact in JP-A-2003-94597 (corresponding to EP1266750A1). Also, there is no description as to introduction of microcapsule into an ink-receptive layer in JP-A-2003-94597 (corresponding to EP1266750A1).

### SUMMARY OF THE INVENTION

Therefore, an object of the present invention is to provide a lithographic printing plate precursor which is prevented from displacement of the image formed by an inkjet recording system and which can provide excellent printing aptitude and a method of preparing a lithographic printing plate.

The present invention includes the following items.
(1) A lithographic printing plate precursor comprising a support and an ink-receptive layer containing a microcapsule.
(2) The lithographic printing plate precursor as described in (1) above, wherein the ink-receptive layer further contains an organic fluorine-based compound.
(3) The lithographic printing plate precursor as described in (1) above, wherein the microcapsule has a crosslinked structure.
(4) The lithographic printing plate precursor as described in any one of (1) to (3) above, wherein the microcapsule is a hollow microcapsule.
(5) A method of preparing a lithographic printing plate using a lithographic printing plate precursor having an ink-receptive layer containing a microcapsule on a support comprising a process of forming an image on the ink-receptive layer with inkjet ink by an inkjet recording system.
(6) The method of preparing a lithographic printing plate as described in (5) above, wherein the inkjet ink contains an oleophilic polymer.
(7) The method of preparing a lithographic printing plate as described in (5) or (6) above, wherein the ink-receptive layer further contains a polymerizable compound and the inkjet ink contains a polymerization initiator.
(8) The method of preparing a lithographic printing plate as described in (5) or (6) above, wherein the ink-receptive layer further contains a polymerization initiator and the inkjet ink contains a polymerizable compound.
(9) The method of preparing a lithographic printing plate as described in any one of (5) to (8) above, wherein the ink-receptive layer on which the image has not been formed with the inkjet ink is removed with a gum solution or dampening water.

According to the present invention, since the ink-receptive layer contains a microcapsule, when the inkjet ink is impacted on the ink-receptive layer, the ink is absorbed in the ink-receptive layer so that the coalescence of ink droplets with each other is prevented (the interference of ink droplet impact is prevented), the openings do not arise in the solid portion and the displacement of the image is prevented. Further, since the ink-receptive layer is removed with a gum solution or dampening water (fountain solution) to reveal the surface of support, the printing aptitude of the non-image area is excellent.

Therefore, a lithographic printing plate precursor which is prevented from the displacement of the image formed by an inkjet recording system and which can provide the excellent printing aptitude and a method of preparing a lithographic printing plate can be provided according to the invention.

### DETAILED DESCRIPTION OF THE INVENTION

The present invention will be described in more detail below. The lithographic printing plate precursor according to the invention may be used for forming an image with inkjet ink by an inkjet recording system and comprises a support and an ink-receptive layer containing a microcapsule. According to the invention, the constituting element other than the ink-receptive layer includes a subbing (undercoat) layer and a surface protective (overcoat) layer.

### <Ink-receptive layer>

Initially, the ink-receptive layer according to the invention will be described.

### [Microcapsule]

The ink-receptive layer according to the invention contains a microcapsule.

The microcapsule may be a microcapsule incorporating a part of the constituting component of the ink-receptive layer or a hollow microcapsule. The hollow microcapsule is particularly preferable in the invention.

Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 (the term "JP-B" as used herein means an "examined Japanese patent publication") and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930, 422 and U. S. Patent 3, 111, 407, and an electrolytic dispersion cooling method described in British Patents 952, 807 and 967,074, but the invention should not be construed as being limited thereto.

A preferable microcapsule wall used in the invention has three-dimensional crosslinkage and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into a binder polymer may be introduced into the microcapsule wall.

The microcapsule having a hollow structure can be prepared by adding as an oily component, an unreactive compound to incorporate into a microcapsule at the preparation of microcapsule and volatilizing the unreactive compound incorporated at the coating of an ink-receptive layer on a support. The void ratio of the microcapsule having a hollow structure outside the system is preferably approximately from 1 to 95% by volume, more preferably from 5 to 90% by volume. The void ratio of the microcapsule inside the system can be estimated from the void ratio of the microcapsule outside the system. The void ratio of the microcapsule outside the system is defined as a ratio of the total volume of the unreactive compound to the total volume of the microcapsule.

The average particle size of the microcapsule is preferably from 0.01 to 3.0 µm, more preferably from 0.05 to 2.0 µm, particularly preferably from 0.10 to 1.0 µm. In the range described above, preferable ink-receptive property can be achieved. It is more preferred that variation in the particle size of microcapsule is small as possible and the particle size distribution of microcapsule is close to monodispersity in view of the preparation of a uniform surface and the formation of good image.

The content of the microcapsule in the ink-receptive layer is ordinarily from 1 to 99% by weight, preferably from 5 to 80% by weight.

### [Organic fluorine-based compound]

It is more preferred that the ink-receptive layer according to the invention further contains an organic fluorine-based compound. The organic fluorine-based compound means an organic compound including at least fluorine atom. By using the organic fluorine-based compound, the dot size of ink impacted at the inkjet recording can be reduced. The organic fluorine-based compound is preferably water-dispersible or water-soluble and more preferably a compound having a perfluoroalkyl group described below.

### <Compound having perfluoroalkyl group>

The organic fluorine-based compound preferably used in the invention is a compound represented by formula R_{F}-Rₚₒₗ.

In the formula above, R_{F} represents a straight-chain or branched fluoroalkyl group having 3 or more carbon atoms, and Rₚₒₗ represents a polar group, for example, a carboxylic acid or a salt thereof, a sulfonic acid or a salt thereof, a phosphoric acid or a salt thereof, a sulfuric acid or a salt thereof, a phosphonic acid or a salt thereof, an amino group or a salt thereof, a quaternary ammonium salt, a polyethyleneoxy skeleton, a polypropyleneoxy skeleton, a sulfonamido group, an ether group or a betaine structure.

Among them, a carboxylic acid or a salt thereof, a sulfonic acid or a salt thereof, a phosphoric acid or a salt thereof, a sulfuric acid or a salt thereof or a phosphonic acid or a salt thereof is preferable from the standpoint of high solubility in dampening water and prevention of stain in the non-image area at printing.

Also, as the R_{F}, a group having a CₙF₂ₙ₊₁CₘH₂ₘCOO- skeleton is particularly preferable from the standpoint of preventing the blur of ink, and a group having two or more CₙF₂ₙ₊₁CₘH₂ₘCOO- skeletons per molecule is more preferable, wherein n is an integer of 2 or more, and m is an integer of 1 or more.

Specific examples (F-1) to (F-19) of the organic fluorine-based compound preferably used in the invention are set forth below, but the invention should not be construed as being limited thereto.

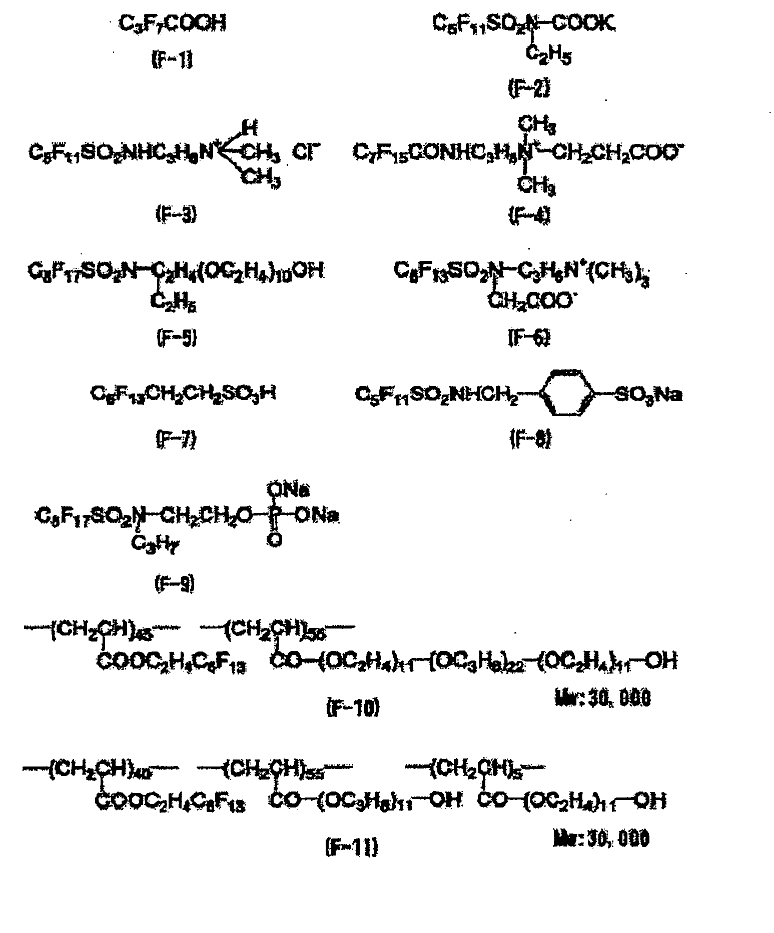

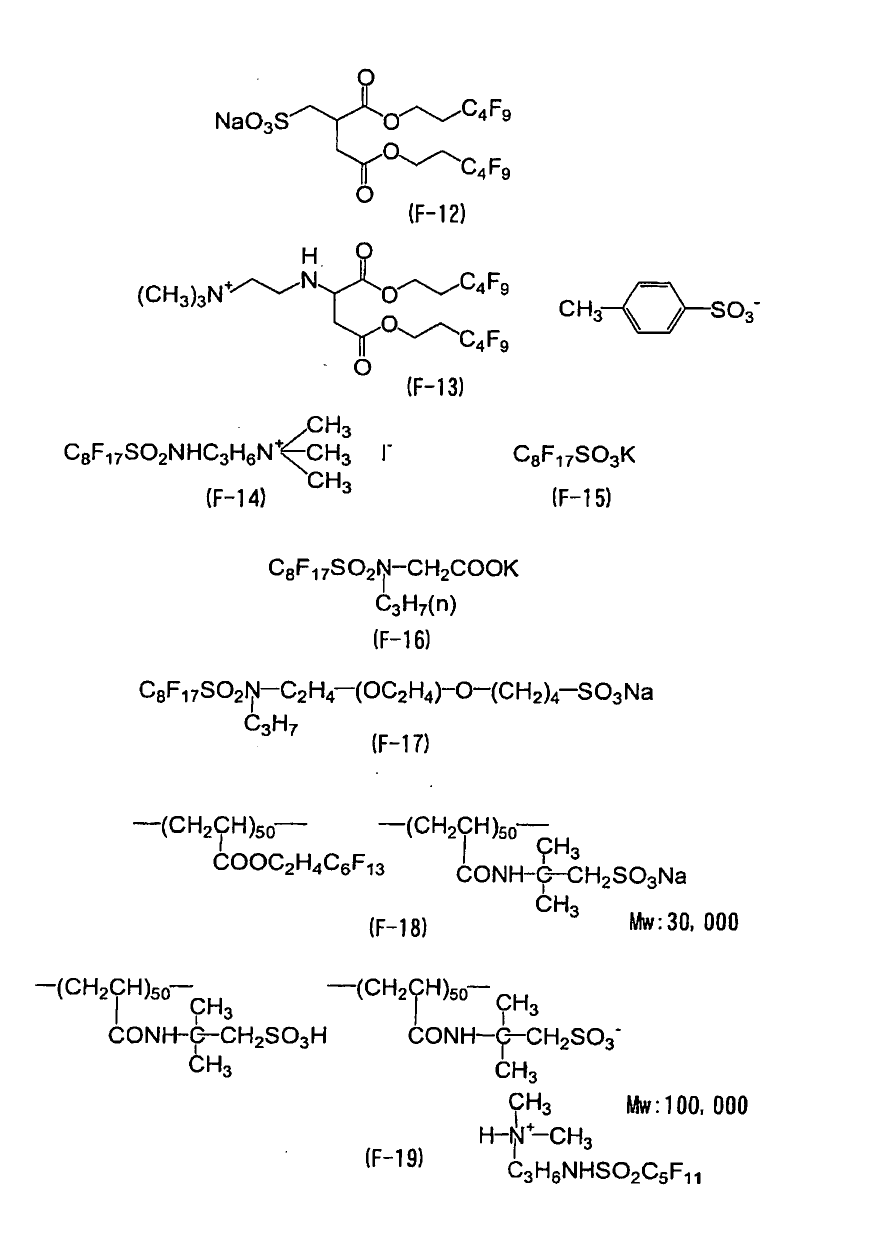

As the organic fluorine-based compound according to the invention, a fluorine-based polymer compound may also be used. Particularly, a fluorine-based polymer compound having a surface active effect and being water-soluble is preferable.

Specific examples of the fluorine-based polymer compound include a copolymer of an acrylate having a fluoroaliphatic group or a methacrylate having a fluoroaliphatic group and a poly(oxyalkylene)acrylate or a poly(oxyalkylene) methacrylate. In the copolymer, the content of the monomer unit of the acrylate or methacrylate having a fluoroaliphatic group is preferably from 7% to 60% by weight based on the weight of the copolymer, and the molecular weight of the copolymer is suitably from 3,000 to 100,000.

The fluoroaliphatic group may be straight-chain or branched and preferably contains 40% by weight or more of fluorine. Specific examples of the acrylate or methacrylate having a fluoroaliphatic group include
N-butylperfluorooctanesulfonamidoethyl acrylate, N-propylperfluorooctanesulfonamidoethyl acrylate and methylperfluorooctanesulfonamidoethyl acrylate. The molecular weight of the polyoxyalkylene group in the poly (oxyalkylene) acrylate or methacrylate is preferably from 200 to 3,000. Examples of the oxyalkylene group include an oxyethylene group, an oxypropylene group and an oxybutylene group, preferably an oxyethylene group or an oxypropylene group. For example, an acrylate or methacrylate having from 8 to 15 moles of oxyethylene groups added is used. If desired, to the terminal of the polyoxyalkylene group may be added, for example, a dimethyl siloxane group, whereby the foaming property is restrained.

The fluorine-based polymer compound is commercially available, and such a commercial product can be used in the invention. Two or more fluorine-based polymer compounds may be used in combination.

Examples of the commercial products include Surflon S-111, S-112, S-113, S-121, S-131, S-141, S-145, S-381 and S-382 produced by Asahi Glass Co., Ltd., Megafac F-110, F120, F-142D, F-150, F-171, F177 and F781 produced by Dainippon Ink & Chemicals, Inc., Fluorad FC-93, FC-95, FC-98, FC-129, FC135, FX-161, FC170C, FC-171 and FC-176 produced by Sumitomo 3M Ltd., and FT-248, FT-448, FT-548, FT-624, FT-718 and FT-738 produced by Bayer Japan Ltd.

The content of the organic fluorine-based compound in the ink-receptive layer is preferably from 0.1 to 50% by weight, and more preferably from 1 to 30% by weight.

### [Hydrophilic resin]

In the ink-receptive layer according to the invention, a hydrophilic resin may also be used. The hydrophilic resin is effective, for example, in dispersion stabilization of the microcapsule.

Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.

Specific examples of the hydrophilic polymer include gum arabic, casein, gelatin, a starch derivative, carboxymethyl cellulose or a sodium salt thereof, cellulose acetate, sodium alginate, a vinyl acetate-maleic acid copolymer, a styrene-maleic acid copolymer, polyacrylic acid or a salt thereof, polymethacrylic acid or a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, a polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, polyvinyl pyrrolidone, an alcohol-soluble nylon and a polyether of 2,2-bis(4-hydroxyphenyl)propane with epichlorohydrin.

The content of the hydrophilic polymer in the ink-receptive layer is ordinarily from 1 to 90% by weight, preferably from 5 to 70% by weight.

### [Polymerizable compound]

To the ink-receptive layer according to the invention, a polymerizable compound may also be added. The polymerizable compound preferably used includes, for example, known radical polymerizable or cationic polymerizable monomers or oligomers. The monomers or oligomers used include a (meth)acrylate, a (meth) acrylamide, (meth) acrylic acid, maleic acid or a derivative thereof, a styrene, an olefin, a vinyl ether, a vinyl ester, an epoxy compound, an oxetane compound and a cyclic ester.

### [Radical polymerizable monomer]

The (meth)acrylate for use in the invention includes, for example, the following compounds. Specific examples of the monofunctional (meth)acrylate include hexyl (meth)acrylate, 2-ethylhexyl (meth)acrylate, tert-octyl (meth)acrylate, isoamyl (meth)acrylate, decyl (meth)acrylate, isodecyl (meth)acrylate, stearyl (meth)acrylate, isostearyl (meth)acrylate, cyclohexyl (meth)acrylate, 4-n-butylcyclohexyl (meth)acrylate, bornyl (meth)acrylate, isobornyl (meth)acrylate, benzyl (meth)acrylate, 2-ethylhexyldiglycol (meth)acrylate, butoxtethyl (meth)acrylate, 2-chloroethyl (meth)acrylate, 4-bromobutyl (meth)acrylate, cyanoethyl (meth)acrylate, benzyl (meth)acrylate, butoxymethyl (meth)acrylate, 3-methoxybutyl (meth)acrylate, an alkoxymethyl (meth)acrylate, an alkoxyethyl (meth)acrylate, 2-(2-methoxyethoxy)ethyl (meth)acrylate, 2-(2-butoxyethoxy)ethyl (meth)acrylate, 2,2,2-tetrafluoroethyl (meth)acrylate, 1H,1H,2H,2H-perflorodecyl (meth)acrylate, 4-butylphenyl (meth)acrylate, phenyl (meth)acrylate, 2,4,5-tetramethylphenyl (meth)acrylate, 4-chlorophenyl (meth)acrylate, phenoxymethyl (meth)acrylate, phenoxyethyl (meth)acrylate, glycidyl (meth)acrylate, glycidyloxybutyl (meth)acrylate, glycidyloxyethyl (meth)acrylate, glycidyloxypropyl (meth)acrylate, tetrahydrofuryl (meth)acrylate, a hydroxyalkyl (meth)acrylate (for example, 2-hydroxyethyl (meth)acrylate, 3-hydroxypropyl (meth)acrylate, 2-hydroxypropyl (meth)acrylate, 2-hydroxybutyl (meth)acrylate, 4-hydroxybutyl (meth)acrylate or 3-hydroxypropyl (meth)acrylate), dimethylaminoethyl (meth) acrylate, diethylaminoethyl (meth)acrylate, dimethylaminopropyl (meth)acrylate, diethylaminopropyl (meth)acrylate, trimethoxysilylpropyl (meth)acrylate, trimethylsilylpropyl (meth)acrylate, polyethyleneoxide monomethyl ether (meth)acrylate, oligoethyleneoxide monomethyl ether (meth)acrylate, polyethyleneoxide (meth)acrylate, oligoethyleneoxide (meth)acrylate, an oligoethyleneoxide monoalkyl ether (meth)acrylate, a polyethyleneoxide monoalkyl ether (meth)acrylate, dipropylene glycol (meth)acrylate, a polypropyleneoxide monoalkyl ether (meth)acrylate, an oligopropyleneoxide monoalkyl ether (meth)acrylate, 2-methacryloyloxyethylsuccinic acid, 2-methacryloyloxyhexahydrophthalic acid, 2-methacryloyloxyethyl-2-hydroxypropyl phthalate, butoxydiethylene glycol (meth)acrylate, trifluoroethyl (meth)acrylate, perfluorooctylethyl (meth)acrylate, 2-hydroxy-3-phenoxypropyl (meth)acrylate, EO-modified phenol (meth)acrylate, EO-modified cresol (meth)acrylate, EO-modified nonylphenol (meth)acrylate, PO-modified nonylphenol (meth)acrylate and EO-modified 2-ethylhexyl (meth)acrylate.

Specific examples of the difunctional (meth)acrylate include 1,6-hexanediol di(meth)acrylate, 1,10-decanediol di(meth)acrylate, neopentyl glycol di(meth)acrylate, 2,4-dimethyl-1,5-pentanediol di(meth)acrylate, butylethylpropanediol di(meth)acrylate, ethoxylated cyclohexanemethanol di(meth)acrylate, polyethylene glycol di(meth)acrylate, oligoethylene glycol di(meth)acrylate, ethylene glycol di(meth)acrylate, 2-ethyl-2-butylbutanediol di(meth)acrylate, hydroxypivalic acid neopentyl glycol di(methacrylate), EO-modified bisphenol A di(meth)acrylate, bisphenol F polyethoxydi(meth)acrylate, polypropylene glycol di(meth)acrylate, oligopropylene glycol di(meth)acrylate, 1,4-butanediol di(meth)acrylate, 2-ethyl-2-butylpropanediol di (meth) acrylate, 1, 9-nonanediol di (meth) acrylate, propoxylated ethoxylated bisphenol A di(meth)acrylate and tricyclodecane di(meth)acrylate.

Specific examples of trifunctional (meth)acrylate include trimethylolpropane tri(meth)acrylate, trimethylolethane tri(meth)acrylate, trimethylolpropane alkylene oxide-modified tri(meth)acrylate, pentaerythritol tri(meth)acrylate, dipentaerythritol tri(meth)acrylate, trimethylolpropane tri((meth)acryloyloxypropyl) ether, isocyanuric acid alkylene oxide-modified tri(meth)acrylate, propionic acid dipentaerythritol tri(meth)acrylate, tri((meth)acryloyloxyethyl) isocyanurate, hydroxypivaldehyde-modified dimethylolpropane tri(meth)acrylate, sorbitol tri(meth)acrylate, propoxylated trimethylolpropane tri(meth)acrylate and ethoxylated glycerol triacrylate.

Specific examples of tetrafunctional (meth)acrylate include pentaerythritol tetra(meth)acrylate, sorbitol tetra(meth)acrylate, ditrimethylolpropane tetra(meth)acrylate, propionic acid dipentaerythritol tetra(meth)acrylate and ethoxylated pentaerythritol tetra(meth)acrylate.

Specific examples of pentafunctional (meth)acrylate include sorbitol penta(meth)acrylate and dipentaerythritol penta(meth)acrylate.

Specific examples of hexafunctional (meth) acrylate include dipentaerythritol hexa(meth)acrylate, sorbitol hexa(meth)acrylate, phosphazene alkylene oxide-modified hexa(meth)acrylate and caprolactone-modified dipentaerythritol hexa(meth)acrylate.

The term "(meth)acrylate" as used herein means an abbreviatory notation indicating both acrylate and methacrylate.

Monomers other than the (meth)acrylate include the following monomers.

Specific examples of (meth)acrylamide include (meth)acrylamide, N-methyl(meth)acrylamide, N-ethyl(meth)acrylamide, N-propyl(meth)acrylamide, N-n-butyl(meth)acrylamide, N-tert-butyl(meth)acrylamide, N-butoxymethyl(meth)acrylamide, N-isopropyl(meth)acrylamide, N-methylol(meth)acrylamide, N,N-dimethyl(meth)acrylamide, N,N-diethyl(meth)acrylamide and (meth)acryloylmorpholine. The term "(meth)acrylamide" as used herein means an abbreviatory notation indicating both acrylamide and methacrylamide.

Specific examples of olefin include dicyclopentadiene, ethylene, propylene, 1-butene, 1-pentene, vinyl chloride, vinylidene chloride, isoprene, chloroprene, butadiene, 2,3-dimethylbutadiene and cyclohexadiene.

Specific examples of styrene include styrene, methylstyrene, dimethylstyrene, trimethylstyrene, ethylstyrene, isopropylstyrene, chloromethylstyrene, methoxystyrene, acetoxystyrene, chlorostyrene, dichlorostyrene, bromostyrene, methyl vinylbenzoate, 3-methylstyrene, 4-methylstyrene, 3-ethylstyrene, 4-ethylstyrene, 3-propylstyrene, 4-propylstyrene, 3-butylstyrene, 4-butylstyrene, 3-hexylstyrene, 4-hexylstyrene, 3-octylstyrene, 4-octylstyrene, 3-(2-ethylhexyl)styrene, 4-(2-ethylhexyl)styrene, allylstyrene, isopropenylstyrene, butenylstyrene, octenylstyrene, 4-tert-butoxycarbonylstyrene, 4-methoxystyrene and 4-tert-butoxystyrene.

Specific examples of vinyl ether include methyl vinyl ether, butyl vinyl ether, hexyl vinyl ether, methoxy vinyl ether, 2-ethylhexyl vinyl ether, methoxyethyl vinyl ether, cyclohexyl vinyl ether, chloroethyl vinyl ether and triethylene glycol divinyl ether.

Other radical polymerizable monomer includes butyl crotonate, hexyl crotonate, dimethyl itaconate, dibutyl itaconate, diethyl maleate, dimethyl maleate, dibutyl maleate, diethyl fumarate, dimethyl fumarate, methyl vinyl ketone, phenyl vinyl ketone, methoxyethyl vinyl ketone, N-vinyloxazolidone, N-vinylpyrrolidone, vinylformamide, vinylidene chloride, methylene malononitrile, vinylidene, diphenyl-2-acryloyloxyethyl phosphate, diphenyl-2-methacryloyloxyethyl phosphate, dibutyl-2-acryloyloxyethyl phosphate, dioctyl-2-methacryloyloxyethyl phosphate, vinyl acetate, vinyl benzoate and N-vinylcarbazole.

### [Cationic polymerizable monomer]

The cationic polymerizable monomer includes an oxetane, for example, 3-ethyl-3-(hydroxymethyl)oxetane, 3-ethyl-3-(phenoxymethyl)oxetane, 3-ethyl-3-(2-ethylhexyloxymethyl)oxetane, bis[1-ethyl(3-oxetanyl)methyl ether] or bis[1-ethyl(3-oxetanyl)methyl]xylylene ether.

The cationic polymerizable monomer also includes an epoxy, for example, (3',4'-epoxycyclohexane)methyl-3,4-epoxycyclohexane carboxylate, 1,2,8,9-diepoxylimonene or bisphenol A diglycidyl ether.

### [Radical polymerizable and cationic polymerizable monomer]

Examples of the radical polymerizable and cationic polymerizable monomer include 4-vinylcyclohexene-1,2-epoxide, 3-ethyl-3-(acryloyloxymethyl)oxetane and 3-ethyl-3-(methacryloyloxymethyl)oxetane.

The content of the polymerizable compound in the ink-receptive layer is ordinarily from 0 to 90% by weight, preferably from 0 to 70% by weight. However, the polymerizable compound and the polymerization initiator described below are not present at the same time in the ink-receptive layer.

To the ink-receptive layer according to the invention, a polymerization initiator may also be added. The polymerization initiator preferably used includes, for example, known photopolymerization initiators for radical polymerization or cationic polymerization used in a radiation curable type ink composition. Other photopolymerization initiators used in the invention include compounds which undergo chemical change by the action of light or by the mutual action of a sensitizing dye in its electron-excited state to generate at least one of a radical, an acid and a base. Any photopolymerization initiators known in the art can be specifically used without limitation. Preferable examples of the photopolymerization initiator include an aromatic ketone, a benzoin derivative, for example, benzoin or benzoin ether, an acylphosphine oxide compound, an onium salt, for example, a sulfonium salt or an iodonium salt, an organic peroxide, a hexaarylbiimidazole compound, a ketoxime ester, a borate salt, an azinium compound, a metallocene compound and a compound having a carbon-halogen bond. While these compounds exhibit polymerization initiating function mainly in the ultraviolet region, they can be spectrally sensitized to visible light or an infrared ray according to a combination with an appropriate sensitizer.

The content of the polymerization initiator in the ink-receptive layer is ordinarily from 0 to 50% by weight, preferably from 0 to 30% by weight. However, the polymerization initiator and the polymerizable compound described above are not present at the same time in the ink-receptive layer.

### [Formation of ink-receptive layer]

The ink-receptive layer according to the invention is formed by dispersing or dissolving each of the necessary constituting components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.

The ink-receptive layer according to the invention may also be formed by preparing plural coating solutions by dispersing or dissolving the same or different components described above into the same or different solvents and conducting repeatedly plural coating and drying.

The coating amount (solid content) of the ink-receptive layer on the support after the coating and drying may be varied depending on the use, but ordinarily, it is preferably from 0.01 to 5 g/m², more preferably from 0.1 to 3.0 g/m². In the range described above, the preferable sensitivity and good film property of the ink-receptive layer can be obtained.

Various methods can be used for the coating. Examples of the method include bar coater coating, spin coating, spray coating, curtain coating, dip coating, air knife coating, blade coating and roll coating.

### [Support]

The support for use in the lithographic printing plate precursor according to the invention is not particularly restricted as long as it is a dimensionally stable plate-like material. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials conventionally known and used can be appropriately utilized.

The thickness of the support is preferably from 0.1 to 0.6 mm, more preferably from 0.15 to 0.4 mm, still more preferably from 0.2 to 0.3 mm.

Prior to the use of aluminum plate, a surface treatment, for example, surface roughening treatment or formation of a hydrophilic film is preferably performed. The surface treatment facilitates improvement in the hydrophilic property and ensures adhesion between the ink-receptive layer and the support. In advance of the surface roughening treatment of the aluminum plate, a degreasing treatment, for example, with a surfactant, an organic solvent or an aqueous alkaline solution is conducted for removing rolling oil on the surface thereof, if desired.

### <Surface roughening treatment>

The surface roughening treatment of the surface of the aluminum plate is conducted by various methods and includes, for example, mechanical surface roughening treatment, electrochemical surface roughening treatment (surface roughening treatment of electrochemically dissolving the surface) and chemical surface roughening treatment (surface roughening treatment of chemically dissolving the surface selectively).

As the method of the mechanical surface roughening treatment, a known method, for example, a ball grinding method, a brush grinding method, a blast grinding method or a buff grinding method can be used.

The electrochemical surface roughening treatment method includes, for example, a method of conducting it by passing alternating current or direct current in an electrolyte containing an acid, for example, hydrochloric acid or nitric acid. Also, a method of using a mixed acid described in JP-A-54-63902 can be employed.

### <Formation of hydrophilic film>

The method for providing a hydrophilic film is not particularly restricted and, for example, an anodic oxidation method, a deposition method, a CVD method, a sol-gel method, a sputtering method, an ion-plating method or a diffusion method can be appropriately used. Further, a method of coating a solution containing hollow particles in a hydrophilic resin or a sol-gel solution can also be used.

Among them, a treatment forming an oxide by the anodic oxidation method, that is, an anodic oxidation treatment is most preferably used. The anodic oxidation treatment can be conducted according to a method conventionally used in the field of art. Specifically, alternating current or direct current is supplied to an aluminum plate in an aqueous solution or non-aqueous solution containing sulfuric acid, phosphoric acid, chromic acid, oxalic acid, sulfamic acid, benzenesulfonic acid or a combination of two or more thereof to form an anodized film which is a hydrophilic film is formed on the surface of aluminum plate. Since the condition of the anodic oxidation treatment may vary depending on the electrolyte used, it cannot be definitely specified, however, it is ordinarily suitable that the concentration of the electrolyte is from 1 to 80% by weight, the liquid temperature is from 5 to 70°C, the current density is from 0.5 to 60 A/dm², the voltage is from 1 to 200 V and the electrolysis time is from 1 to 1,000 seconds. Of the anodic oxidation treatments, a method of conducting anodic oxidation treatment in a sulfuric acid electrolyte at a high current density described in British Patent 1,412,768 and a method of conducting anodic oxidation treatment using phosphoric acid as the electrolyte described in U.S. Patent 3,511,661 are preferable. Further, a multiple-stage anodic oxidation treatment comprising, for example, an anodic oxidation treatment in sulfuric acid and then an anodic oxidation treatment in phosphoric acid can also be performed.

According to the invention, the amount of the anodized film is preferably 0.1 g/m² or more, more preferably 0.3 g/m² or more, still more preferably 2 g/m² or more, yet still more preferably 3.2 g/m² or more, in view of scratch resistance and printing durability. Since a large amount of energy is necessary to from the anodized film of large thickness, the amount of the anodized film is preferably 100 g/m² or less, more preferably 40 g/m² or less, still more preferably 20 g/m² or less.

On the surface of the anodized film, minute concave portions called micropores distributed across the surface are formed. The density of the micropore present in the anodized film can be adjusted by appropriately selecting the treatment conditions. By increasing the density of the micropore, the thermal conductivity in the film thickness direction of the anodized film can be decreased. The diameter of the micropore can be adjusted by appropriately selecting of the treatment conditions. By increasing the diameter of the micropore, the thermal conductivity in the film thickness direction of the anodized film can be decreased.

According to the invention, it is preferred to conduct a pore-widening treatment for enlarging the diameter of the micropore after the anodic oxidation treatment for the purpose of decreasing the thermal conductivity. The pore-widening treatment is conducted by immersing the aluminum substrate having the anodized film formed thereon in an aqueous acid solution or an aqueous alkali solution to dissolve the anodized film, whereby the diameter of the micropore is enlarged. The pore-widening treatment is conducted so as to dissolve the anodized film in an amount ranging preferably from 0.01 to 20 g/m², more preferably from 0.1 to 5 g/m², particularly preferably from 0.2 to 4 g/m².

When the pore-widening treatment is conducted with the aqueous acid solution, an aqueous solution of an inorganic acid, for example, sulfuric acid, phosphoric acid, nitric acid or hydrochloric acid or a mixture thereof is preferably used. The concentration of the aqueous acid solution is preferably from 10 to 1,000 g/liter, more preferably from 20 to 500 g/liter. The temperature of the aqueous acid solution is preferably from 10 to 90°C, more preferably from 30 to 70°C. The immersion time in the aqueous acid solution is preferably from 1 to 300 seconds, more preferably from 2 to 100 seconds. When the pore-widening treatment is conducted with the aqueous alkali solution, an aqueous solution of at least one alkali selected from the group consisting of sodium hydroxide, potassium hydroxide and lithium hydroxide is preferably used. The pH of the aqueous alkali solution is preferably from 10 to 13, more preferably from 11.5 to 13.0. The temperature of the aqueous alkali solution is preferably from 10 to 90°C, more preferably from 30 to 50°C. The immersion time in the aqueous alkali solution is preferably from 1 to 500 seconds, more preferably from 2 to 100 seconds. However, when the diameter of the micropore of the uppermost surface increases too much, stain resistance at printing degrades and thus, the diameter of the micropore of the uppermost surface is preferably 40 nm or less, more preferably 20 nm or less, most preferably 10 nm or less. According to the more preferable configuration of the anodized film for satisfying both the thermal conductivity and the stain resistance, the diameter of the micropore of the uppermost surface is from 0 to 40 nm and the diameter of the micropore of the inner portion is from 20 to 300 nm. It is known, for example, that the diameter of the pore formed is proportional to the electrolysis voltage at the electrolysis when the same kind of the electrolyte is used. Utilizing this property, when the electrolysis voltage is gradually increased, pores in which the bottom portion has an enlarged diameter can be formed. It is also known that the diameter of the pore is varied when the kind of the electrolyte is changed and that the diameter of the pore increases in the order of sulfuric acid, oxalic acid and phosphoric acid. Thus, a method of anodic oxidation can be used in which sulfuric acid is used as the electrolyte in the first stage and phosphoric acid is used as the electrolyte in the second stage. Further, the support prepared by conducting the anodic oxidation treatment and/or pore-widening treatment may be subjected to the pore-sealing treatment described below.

The hydrophilic film may be an inorganic film prepared, for example, by a sputtering method or a CVD method in addition to the anodized film described above. The compound for constituting the inorganic film includes, for example, an oxide, a nitride, a silicide, a boride and a carbide. The inorganic film may be composed of only one compound or a mixture of compounds. Specific examples of the compound constituting the inorganic film include aluminum oxide, silicon oxide, titanium oxide, zirconium oxide, hafnium oxide, vanadium oxide, niobium oxide, tantalum oxide, molybdenum oxide, tungsten oxide, chromium oxide, aluminum nitride, silicon nitride, titanium nitride, zirconium nitride, hafnium nitride, vanadium nitride, niobium nitride, tantalum nitride, molybdenum nitride, tungsten nitride, chromium nitride, silicon nitride, boron nitride, titanium silicide, zirconium silicide, hafnium silicide, vanadium silicide, niobium silicide, tantalum silicide, molybdenum silicide, tungsten silicide, chromium silicide, titanium boride, zirconium boride, hafnium boride, vanadium boride, niobium boride, tantalum boride, molybdenum boride, tungsten boride, chromium boride, aluminum carbide, silicon carbide, titanium carbide, zirconium carbide, hafnium carbide, vanadium carbide, niobium carbide, tantalum carbide, molybdenum carbide, tungsten carbide and chromium carbide.

### <Pore-sealing treatment>

According to the invention, the aluminum support having the hydrophilic film formed as described above may be subjected to a pore-sealing treatment. The pore-sealing treatment for use in the invention includes a pore-sealing treatment of the anodized film with a pressurized water vapor or hot water described in JP-A-4-176690 and JP-A-11-301135. Further, a known method, for example, a silicate treatment, an aqueous dichromate solution treatment, a nitrite treatment, an ammonium acetate treatment, an electrodeposition pore-sealing treatment, a triethanolamine treatment, a barium carbonate treatment or hot water treatment containing a extremely slight amount of phosphate. The manner of formation of a pore-sealing film is different from each other according to the method of pore-sealing treatment. For instance, the pore-sealing film is formed from the bottom of the pore in the electrodeposition pore-sealing treatment, and the pore-sealing film is formed from the upper portion of the pore in the pore-sealing treatment with water vapor. In addition to the above methods, an immersion treatment in a solution, a spray treatment, a coating treatment, a deposition treatment, sputtering, ion plating, thermal spraying, plating and the like are exemplified, but the invention should not be construed as being limited thereto. Among them, a pore-sealing treatment using particles having an average diameter of 8 to 800 nm described in JP-A-2002-214764 is particularly preferable.

In the pore-sealing treatment using particles, the average diameter of the particle is ordinarily from 8 to 800 nm, preferably from 10 to 500 nm, more preferably from 10 to 150 nm. In the range described above, the particle is prevented from entering into the inside of the micropore present in the hydrophilic film so that the effect of achieving high sensitivity is sufficiently obtained and the adhesion to the ink-receptive layer is increased to improve printing durability. The thickness of the particle layer is preferably from 8 to 800 nm, more preferably from 10 to 500 nm.

The method of forming the particle layer includes, for example, an immersion treatment in a solution, a spray treatment, a coating treatment, an electrolysis treatment, a deposition treatment, sputtering, ion plating, thermal spraying, plating and the like are exemplified, but the invention should not be construed as being limited thereto.

The electrolysis treatment can be conducted using direct current or alternating current. The waveform of the alternating current used for the electrolysis treatment includes, for example, a sine wave, a rectangular wave, a triangular waver or a trapezoidal wave. The frequency of the alternating current is preferably from 30 to 200 Hz, more preferably from 40 to 120 Hz, from the standpoint of cost for the production of power supply. In the case of using the alternating current having a trapezoidal waveform, the time (tp) necessary for the electric current to reach from zero to a peak is preferably from 0.1 to 2 msec, more preferably from 0.3 to 1. 5 msec. When the tp is less than 0.1 msec, due to the influence of impedance of the power supply circuit a large power supply voltage is necessary at the rising time of the current waveform to increase the cost of power supply facilities in some cases.

As the hydrophilic particle, Al₂O₃, TiO₂, SiO₂ and ZrO₂ are preferably used individually or in combination of two or more thereof. The electrolyte is prepared, for example, by suspending the hydrophilic particle in water or the like so that the content of the hydrophilic particle is from 0.01 to 20% by weight. The pH of the electrolyte can be controlled by adding, for example, sulfuric acid, for the purpose of charging positively or negatively the electrolyte. The electrolysis treatment is conducted on the aluminum plate as the cathode, for example, using direct current and the electrolyte described above, under conditions of voltage of 10 to 200 for a period of 1 to 600 seconds. According to the method, the opening of the micropore present in the anodized film can be closed while remaining a void inside of the micropore.

For the pore-sealing treatment, methods of providing a layer by coating are also illustrated. Examples of the layer include a layer comprising a compound having at least one amino group and at least one group selected from a carboxyl group and a salt group thereof and a sulfo group and a salt group thereof described in JP-A-60-149491, a layer comprising a compound selected from a compound having at least one amino group and at least one hydroxy group and a salt thereof described in JP-A-60-232998, a layer containing a phosphate described in JP-A-62-19494, and a layer comprising a polymer compound including as a repeating unit, at least one monomer unit having a sulfo group.

Further, methods of providing a layer of carboxymethyl cellulose; dextrin; gum arabic; a phosphonic acid having an amino group, for example, 2-amonoethylphosphonic acid; an organic phosphonic acid, for example, phenylphosphonic acid, naphthylphosphonic acid, alkylphosphonic acid, glycerophosphonic acid, methylenediphosphonic acid and ethylenediphosphonic acid each of which may have a substituent; an organic phosphoric acid ester, for example, phenylphosphoric acid, naphthylphosphoric acid, alkylphosphoric acid and glycerophosphoric acid each of which may have a substituent; an organic phosphinic acid, for example, phenylphosphinic acid, naphthylphosphinic acid, alkylphosphinic acid and glycerophosphinic acid each of which may have a substituent; an amino acid, for example, glycine or β-alanine; or a hydrochloride of hydroxy group-containing amine, for example, triethanolamine hydrochloride are also illustrated.

For the pore-sealing treatment, treatment of coating a silane coupling agent having an unsaturated group may be used. Examples of the silane coupling agent include N-3-(acryloxy-2-hydroxypropyl)-3-aminopropyltriethoxtsilane, (3-acryloxypropy)dimethylmethoxysilane, (3-acryloxypropy)methyldimethoxysilane, (3-acryloxypropy)trimethoxysilane, 3-(N-allylamino)propyltrimethoxysilane, allyldimethoxysilane, allyltriethoxysilane, allyltrimethoxysilane, 3-butenyltriethoxysilane, 2-(chloromethyl)allyltrimethoxysilane, methacrylamidopropyltriethoxysilane, N-3-(methacryloxy-2-hydroxypropyl)-3-aminopropyltriethoxtsila ne, (methacryloxymethyl)dimethylethoxysilane, methacryloxymethyltriethoxysilane, methacryloxymethyltrimethoxysilane, methacroxypropyldimethylethoxysilane, methacroxypropyldimethylmethoxysilane, methacroxypropylmethyldiethoxysilane, methacroxypropylmethyldimethoxysilane, methacroxypropylmethyltriethoxysilane, methacroxypropylmethyltrimethoxysilane, methacroxypropyltris(methoxyethoxysilane), methoxydimethylvinylsilane, 1-methoxy-3-(tromethylsyloxy)butadiene, styrylethyltrimethoxysilane, 3-(N-styrylmethyl-2-aminoethylamino)propyltrimethoxysilane hydrochloride, vinyldimethylethoxysilane, vinyldiphenylethoxysilane, vinylmethyldiethoxysilane, vinylmethyldimethoxysilane, O-(vinyloxyethyl)-N-(triethoxysilylpropyl)urethane, vinyltriethoxysilane, vinyltrimethoxysilane, vinyltri-tert-butoxysilane, vinyltriisopropoxysilane, vinyltriphenoxysilane, vinyltris(2-methoxyethoxy)silane and diallylaminopropylmethoxysilane. Particularly, the silane coupling agent having a methacryloyl group or acryloyl group which has high reactivity as the unsaturated group is preferable.

In addition, a sol-gel coating treatment described in JP-A-5-50779, a coating treatment of a phosphonic acid described in JP-A-5-246171, a treatment by coating a material for backcoat described in JP-A-6-234284, JP-A-6-191173 and JP-A-6-230563, a treatment of a phosphonic acid described in JP-A-6-262872, a coating treatment described in JP-A-6-297875, an anodic oxidation treatment described in JP-A-10-109480, and an immersion treatment described in JP-A-2000-81704 and JP-A-2000-89466 are exemplified and any method may be used.

After the formation of hydrophilic film, the surface of the aluminum support is subjected to a hydrophilizing treatment, if desired. The hydrophilizing treatment includes an alkali metal silicate method described in U.S. Patents 2,714,066, 3,181,461, 3,280,734 and 3, 902, 734 . In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U. S. Patents 3, 276, 868, 4, 153, 461 and 4, 689, 272.

In the case of using a support having a surface of insufficient hydrophilicity, for example, a polyester film, in the invention, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support in the invention, it is preferred to provide an antistatic layer on the hydrophilic layer side, opposite side to the hydrophilic layer or both sides. When the antistatic layer is provided between the support and the hydrophilic layer, it also contributes to improve the adhesion property of the hydrophilic layer to the support. As the antistatic layer, a polymer layer having fine particles of metal oxide or a matting agent dispersed therein described in JP-A-2002-79772 can be used.

The support preferably has a center line average roughness of 0.10 to 1.2 µm. In the range described above, good adhesion property to the ink-receptive layer, good printing durability, and good resistance to stain can be achieved. The color density of the support is preferably from 0.15 to 0.65 in terms of the reflection density value. In the range described above, good image-forming property by preventing halation at the image exposure and good aptitude for plate inspection after development can be achieved.

### (Backcoat layer)

After applying the surface treatment to the support or forming an undercoat layer on the support, a backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### (Undercoat layer)

In the lithographic printing plate precursor according to the invention, particularly in the lithographic printing plate precursor of on-machine development type, an undercoat layer is provided between the support and the ink-receptive layer, if desired. The undercoat layer makes removal of the ink-receptive layer from the support in the unexposed area easy so that the on-machine development property can be improved.

As a compound for the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified.

As the most preferable compound for undercoat layer, a polymer resin obtained by copolymerization of a monomer having an adsorbing group, a monomer having a hydrophilic group and a monomer having a crosslinkable group is exemplified.

The essential component in the polymer for undercoating is an adsorbing group to the hydrophilic surface of the support. Whether adsorptivity to the hydrophilic surface of the support is present or not can be judged, for example, by the following method.

A test compound is dissolved in an easily soluble solvent to prepare a coating solution, and the coating solution is coated and dried on a support so as to have the coating amount after drying of 30 mg/m². After thoroughly washing the support coated with the test compound using the easily soluble solvent, the residual amount of the test compound that has not been removed by the washing is measured to calculate the adsorption amount to the support. For measuring the residual amount, the residual amount of the test compound may be directly determined, or may be calculated by determining the amount of the test compound dissolved in the washing solution. The determination for the compound can be performed, for example, by X-ray fluorescence spectrometry measurement, reflection absorption spectrometry measurement or liquid chromatography measurement. The compound having the adsorptivity to support is a compound that remains by 1 mg/m² or more even after conducting the washing treatment described above.

The adsorbing group to the hydrophilic surface of the support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the surface of the support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OP0₃H₂, -CONHSO₂-, -SO₂NHSO₂- and -COCH₂COCH₃. Among them, -OPO₃H₂ and -PO₃H₂ are particularly preferred. The acid group may be the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. Among them, the ammonium group, phosphonium group and sulfonium group are preferred, the ammonium group and phosphonium group are more preferred, and the ammonium group is most preferred.

Particularly preferable examples of the monomer having the adsorbing group include compounds represented by the following formula (IV) or (V):

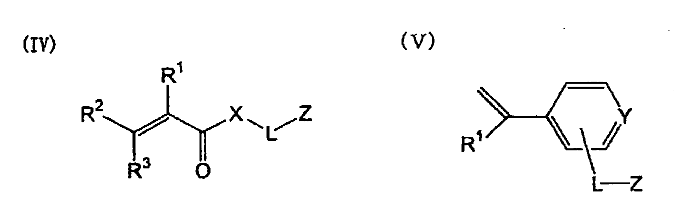

In formulae (IV) and (V), R¹, R² and R³ each independently represents a hydrogen atom, halogen atom or an alkyl group having from 1 to 6 carbon atoms. R¹, R² and R³ each independently represents preferably a hydrogen atom or an alkyl group having from 1 to 6 carbon atoms, more preferably a hydrogen atom or an alkyl group having from 1 to 3 carbon atoms, most preferably a hydrogen atom or methyl. It is particularly preferred that R² and R³ each represents a hydrogen atom.

In formula (IV), X represents an oxygen atom (-O-) or an imino group (-NH-). Preferably, X represents an oxygen atom.

In formulae (IV) and (V) , L represents a divalent connecting group. It is preferred that L represents a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of the groups described above with an oxygen atom (-O-), a sulfur atom (-S-), an imino group (-NH-), a substituted imino group (-NR-, where R represents an aliphatic group, an aromatic group or a heterocyclic group) or a carbonyl group (-CO-).

The aliphatic group may form a cyclic structure or a branched structure. The number of carbon atoms of the aliphatic group is preferably from 1 to 20, more preferably from 1 to 15, most preferably from 1 to 10. It is preferred that the aliphatic group is a saturated aliphatic group rather than an unsaturated aliphatic group. The aliphatic group may have a substituent. Examples of the substituent include a halogen atom, a hydroxy group, an aromatic group and a heterocyclic group.

The number of carbon atoms of the aromatic group is preferably from 6 to 20, more preferably from 6 to 15, most preferably from 6 to 10. The aromatic group may have a substituent. Examples of the substituent include a halogen atom, a hydroxy group, an aliphatic group, an aromatic group and a heterocyclic group.

It is preferred that the heterocyclic group has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, where R represents an aliphatic group, an aromatic group or a heterocyclic group), an aliphatic group, an aromatic group and a heterocyclic group.

It is preferred that L represents a divalent connecting group containing a plurality of polyoxyalkylene structures. It is more preferred that the polyoxyalkylene structure is a polyoxyethylene structure. Specifically, it is preferred that L contains -(OCH₂CH₂)ₙ- (n is an integer of 2 or more).

In formulae (IV) and (V), Z represents a functional group adsorbing to the hydrophilic surface of the support.

In formula (V), Y represents a carbon atom or a nitrogen atom. In the case where Y is a nitrogen atom and L is connected to Y to form a quaternary pyridinium group, Z is not mandatory and may represents a hydrogen atom because the quaternary pyridinium group itself exhibits the adsorptivity.

Representative examples of the monomer represented by formula (IV) or (V) are set forth below.

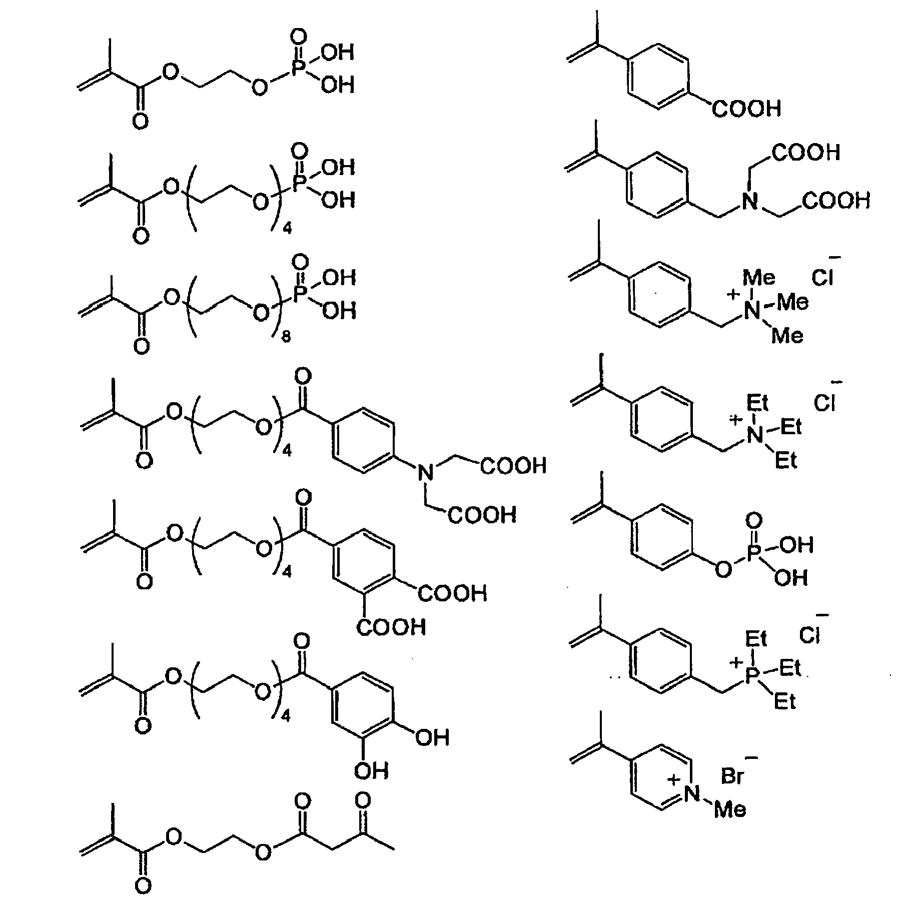

The hydrophilic group included in the polymer resin for the undercoat layer for use in the invention preferably includes, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group. Among them, a sulfonic acid group exhibiting a highly hydrophilic property is preferable. Specific examples of the monomer having a sulfonic acid group include a sodium salt or an amine salt of methallyloxybenzenesulfonic acid, allyloxybenzenesulfonic acid, allylsulfonic acid, vinylsulfonic acid, allylsulfonic acid, p-styrenesulfonic acid, methallylsulfonic acid, acrylamido-tert-butylsulfonic acid, 2-acrylamido-2-methylpropanesulfonic acid or (3-acryloyloxypropyl)buthylsulfonic acid. Among them, from the standpoint of the hydrophilic property and handling property in the synthesis thereof, sodium salt of 2-acrylamido-2-methylpropanesulfonic acid is preferable.

It is preferred that the water-soluble polymer resin for the undercoat layer according to the invention has a crosslinkable group. The crosslinkable group acts to improve the adhesion to the image area. In order to impart the crosslinking property to the polymer resin for the undercoat layer, introduction of a crosslinkable functional group, for example, an ethylenically unsaturated bond into the side chain of the polymer or introduction by formation of a salt structure between a polar substituent of the polymer resin and a compound containing a substituent having a counter charge to the polar substituent of the polymer resin and an ethylenically unsaturated bond is used.

Examples of the polymer having the ethylenically unsaturated bond into the side chain thereof include a polymer of an ester or amide of acrylic acid or methacrylic acid, which is a polymer wherein the ester or amide residue (R in -COOR or -CONHR) has the ethylenically unsaturated bond.

Examples of the residue (R described above) having an ethylenically unsaturated bond include -(CH₂)ₙCR₁=CR₂R₃, - (CH₂O)ₙCH₂CR₁=CR₂R₃, - (CH₂CH₂O)ₙCH₂CR₁=CR₂R₃, - (CH₂)ₙNH-CO-O-CH₂CR₁=CR₂R₃, - (CH₂)ₙ-O-CO-CR₁=CR₂R₃ and -(CH₂CH₂O)₂-X (wherein R₁ to R₃ each represents a hydrogen atom, a halogen atom or an alkyl group having from 1 to 20 carbon atoms, an aryl group, alkoxy group or aryloxy group, or R₁ and R₂ or R₁ and R₃ may be combined with each other to form a ring. n represents an integer of 1 to 10. X represents a dicyclopentadienyl residue) .

Specific examples of the ester residue include -CH₂CH=CH₂ (described in JP-B-7-21633) -CH₂CH₂O-CH₂CH=CH₂, -CH₂C (CH₃) =CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂O-Y (wherein Y represents a cyclohexene residue) and -CH₂CH₂OCO-CH=CH₂.

As the monomer having a crosslinkable group for the polymer resin for undercoat layer, an ester or amide of acrylic acid or methacrylic acid having the crosslinkable group described above is preferable.

The content of the crosslinkable group in the polymer resin for undercoat layer (content of the radical polymerizable unsaturated double bond determined by iodine titration) is preferably from 0.1 to 10.0 mmol, more preferably from 1.0 to 7.0 mmol, most preferably from 2.0 to 5.5 mmol, based on 1 g of the polymer resin. In the range above-described, preferable compatibility between the sensitivity and stain resistance and good preservation stability can be achieved.

The weight average molecular weight of the polymer resin for undercoat layer is preferably 5,000 or more, more preferably from 10,000 to 300,000. The number average molecular weight of the polymer resin is preferably 1,000 or more, more preferably from 2,000 to 250,000. The polydispersity (weight average molecular weight/number average molecular weight) thereof is preferably from 1.1 to 10.

The polymer resin for undercoat layer may be any of a random polymer, a block polymer, a graft polymer and the like, and is preferably a random polymer.

As the polymer resin for undercoat layer, known resins having a hydrophilic group can also be used. Specific examples of the resin include gum arabic, casein, gelatin, a starch derivative, carboxy methyl cellulose and a sodium salt thereof, cellulose acetate, sodium alginate, vinyl acetate-maleic acid copolymer, styrene-maleic acid copolymer, polyacrylic acid and a salt thereof, polymethacrylic acid and a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, a polyvinyl alcohol, a hydrolyzed polyvinyl acetate having a hydrolysis degree of 60% by mole or more, preferably 80% by mole or more, a polyvinyl formal, a polyvinyl butyral, polyvinyl pyrrolidone, a homopolymer or copolymer of acrylamide, a homopolymer or polymer of methacrylamide, a homopolymer or copolymer of N-methylolacrylamide, polyvinyl pyrrolidone, an alcohol-soluble nylon, a polyether of 2,2-bis(4-hydroxyphenyl)propane and epichlorohydrin.

The polymer resins for undercoat layer may be used individually or as a mixture of two or more thereof.

The coating amount (solid content) of the undercoat layer is preferably from 0.1 to 100 mg/m², more preferably from 1 to 30 mg/m².

### [Inkjet ink]

The inkjet ink (hereinafter, also simply referred to as "ink") is not particularly restricted and various inks can be used.

For instance, an aqueous ink in which a polymer and a coloring agent is dissolved or dispersed in water, a solvent type ink in which a polymer and a coloring agent is dissolved or dispersed in an organic solvent and a curable type ink containing a compound capable of being cured with irradiation of radiation or heat are exemplified.

With respect to the combination of the ink and ink-receptive layer, the combinations shown in Table 1 below are preferable according to the invention.

**TABLE 1**

| | Ink | Ink-receptive Layer |
|---|---|---|
| A | Solvent type ink or curable type ink | No limit |
| B | Ink which contains polymerization initiator and which may contain polymerizable compound | Ink-receptive Layer which contains polymerizable compound but does not contain polymerization initiator |
| C | Ink which contains polymerizable compound and which may contain polymerization initiator | Ink-receptive Layer which contains polymerization initiator but does not contain polymerizable compound |

The constituting components of the ink are described below. The components are appropriately selected according to the description in Table 1 to use.

### [Solvent]

Examples of the organic solvent include a ketone solvent, for example, acetone or methyl ethyl ketone, an alcohol solvent, for example, methanol, ethanol, propanol, butanol, 1-methoxy-2-propanol, ethylene glycol, diethylene glycol, dipropylene glycol, diethylene glycol monoethyl ether, tripropylene glycol, tripropylene glycol monomethyl ether, methyl lactate or ethyl lactate, an aromatic solvent, for example, toluene, an ester solvent, for example, ethyl acetate, butyl acetate, isopropyl acetate or γ-butyrolactone, an ether solvent, for example, tetrahydrofuran or diethylene glycol diethyl ether, and a hydrocarbon solvent, for example, Isopar G (produced by Exxon Mobil Corp.).

### [Oleophilic polymer]

According to the invention, the ink preferably contains a oleophilic polymer.

As the oleophilic polymer, a (meth)acrylic resin, a polyurethane resin, a polyamide resin, a polyester resin, an epoxy resin, a phenol resin, a polycarbonate resin, a polyvinyl butyral resin, a polyvinyl formal resin, a polyvinyl alcohol resin, polyethylene glycol, polyethylene oxide, polypropylene glycol, a shellac resin, a vinyl resin, a rubber resin, a wax or a natural resin is used.

The weight average molecular weight of the oleophilic polymer for use in the invention is preferably 10,000 or more, more preferably from 30,000 to 1,000,000. The term "oleophilic polymer" as used herein means a polymer having solubility of 5 g or less in 100 g of water at 25°C. The solubility is preferably 3 g or less in 100 g of water at 25°C.

The oleophilic polymer according to the invention is preferably a polymer obtained by using 40 to 100% by mole of a radical polymerizable monomer represented by formula (1) shown below.

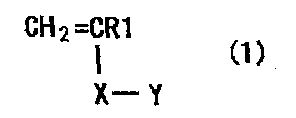

In formula (1), R1 represents a hydrogen atom or a methyl group, X represents a single bond, COO or CONR2, R2 represents a hydrogen atom or a hydrocarbon group having 12 or less carbon atoms, and Y represents a hydrocarbon group having from 1 to 20 carbon atoms. The hydrocarbon group may include an ether bond, an ester bond or an amido bond or may have as a substituent, an OH group, a COOH group or a halogen atom.

Preferable examples of the radical polymerizable monomer are set forth below.

Styrene, p-methoxystyrene, methyl (meth)acrylate, ethyl (meth) acrylate, allyl (meth) acrylate, butyl (meth) acrylate, hexyl (meth)acrylate, 2-ethylhexyl (meth)acrylate, octyl (meth)acrylate, decyl (meth)acrylate, stearyl (meth)acrylate, cyclohexyl (meth) acrylate, bornyl (meth) acrylate, isobornyl (meth)acrylate, benzyl (meth)acrylate, 2-ethylhexyl diglycol (meth)acrylate, butoxyethyl (meth)acrylate, butoxymethyl (meth)acrylate, 3-methoxybutyl (meth)acrylate, 2-(2-methoxyethoxy)ethyl (meth)acrylate, 2-(2-butoxyethoxy)ethyl (meth)acrylate, 2,2,2-tetrafluoroethyl (meth)acrylate, 1H,1H,2H,2H-perfluorodecyl (meth)acrylate, 4-butylphenyl (meth)acrylate, phenyl (meth) acrylate, 2,4,5-tetramethylphenyl (meth)acrylate, 4-chlorophenyl (meth)acrylate, phenoxymethyl (meth)acrylate, phenoxyethyl (meth)acrylate, glycidyl (meth)acrylate, glycidyloxybutyl (meth)acrylate, glycidyloxyethyl (meth)acrylate, glycidyloxypropyl (meth)acrylate, tetrahydrofurfuryl (meth)acrylate, 2-hydroxyethyl (meth)acrylate, 3-hydroxypropyl (meth)acrylate, 2-hydroxypropyl (meth)acrylate, 2-hydroxybutyl (meth)acrylate, 4-hydroxybutyl (meth)acrylate, 3-hydroxypropyl (meth)acrylate), 2-methacryloyloxyethylsuccinic acid, 2-methacryloyloxyhexahydrophthalic acid, 2-methacryloyloxyethyl-2-hydroxypropyl phthalate, butoxydiethylene glycol (meth)acrylate, trifluoroethyl (meth)acrylate, perfluorooctylethyl (meth)acrylate, 2-hydroxy-3-phenoxypropyl (meth)acrylate, (meth)acrylamide, N-butyl(meth)acrylamide, N-p-hydroxyphenyl(meth)acrylamide and p-sulfamoylphenyl(meth)acrylamide.

The term "(meth)acrylate" as used herein means an abbreviatory notation indicating both acrylate and methacrylate. The term "(meth)acryl" as used herein is also same as above.

Known radical polymerizable monomers other than those described above may be used, if desired.

The content of the oleophilic polymer in the ink according to the invention is ordinarily from 1 to 25% by weight, preferably from 2 to 20% by weight, more preferably from 3 to 15% by weight. In the range described above, the effect of improving printing durability and the effect of improving ejection stability at the inkjet are achieved.

The polymerizable compound and polymerization initiator for use in the ink include those described for the ink-receptive layer above. The content of the polymerizable compound in the ink is preferably from 1 to 50% by weight, more preferably from 5 to 40% by weight. The content of the polymerization initiator in the ink is preferably from 0.01 to 20% by weight, more preferably from 0.1 to 10% by weight.

### [Other]

The ink may be colored for the visibility of image. Known dyes or pigments can be used for the coloration. The ink may also contain a surfactant for improving ejection property or a polymerization inhibitor for improving stability of the ink during preservation.

### [Physical property of ink]

With respect to the physical property of the ink, the viscosity at 25°C is preferably from 1 to 100 mPa·s in view of handling at user level. In case of performing the ejection by an inkjet recording apparatus in practice, it is preferred that the viscosity is 2 to 50 mPa·s when the ink temperature is maintained at almost constant temperature in a range of 25 to 100°C.

### [Inkjet recording]

The inkjet recording method according to the invention is described below.

### (Ink retaining means)

With respect to the retention of ink, it is preferred that the ink is filled in a known ink cartridge. It is also possible that the ink is put in a deformable container to form an ink tank as described in JP-A-5-16377. Due to providing a sub-tank, the supply of ink to an ink head is further stabilized as described in JP-A-5-16382. It is also possible to use an ink cartridge which is designed to supply the ink by moving a valve, even when the pressure in the ink supply chamber decreases, as described in JP-A-8-174860. In the ink retaining means, as a method for providing a negative pressure to maintain an adequate meniscus in the head, for example, a method of using the altitude of the ink retaining means, i.e., a hydraulic head pressure, a method of using the capillarity of a filter provided in the ink channel, a method of controlling the pressure by a pump or the like, or a method for providing a negative pressure by the capillarity of an ink absorbent in which the ink is retained as described in JP-A-50-74341 is appropriately used.

### (Ink supply channel)

As a method for supplying the ink from the ink retaining means to the head, a method of directly connecting the ink retaining means to the head unit or a method of connecting the ink retaining means to the head unit through a channel, for example, a tube may be used. The ink retaining means and channel are preferably made of a material having good wettability with the ink or a material subjected to a surface treatment to have good wettability.

### (Head)

As a method for ejecting the ink, a method of continuously ejecting ink droplets and selectively controlling whether the ink droplet is impacted on a medium or not by deflection of the ink droplet in response to the image as described in JP-A-5-104725 or a so-called on-demand system wherein ink droplets are ejected only on the region necessary for the image may be used. The on-demand system may be a system in which an ink pressure is generated by deformation of structure using, for example, a piezo (piezoelectric) element to eject ink droplet as described in JP-A-5-16349 or a system in which an ink droplet is ejected by a pressure generated due to expansion associated with aerification based on heat energy as described in JP-A-1-234255. It may also be a system in which the ejection to a medium is controlled by an electric field as described in JP-A-2001-277466.

A nozzle having a configuration as described in JP-A-5-31908 can be used. Also, it is possible to conduct high speed recording by providing a plurality of head units having plural lines of nozzles.

Further, a high speed image formation can be performed by arranging nozzles in length same as or longer than the width of the image to form a so-called line head and ejecting the ink from these nozzles while simultaneously moving a medium as described in JP-A-63-160849.

The surface of a nozzle can be prevented from adhesion of mist of ink droplet or adhesion of ink droplet by performing a surface treatment as described in JP-A-5-116327. Even though such a surface treatment is conducted, contamination may adhere on the surface in some cases. Therefore, it is preferred to clean the nozzle with a blade as described in JP-A-6-71904. In the case where the ink is not ejected from nozzles equally, in order to maintain the meniscus stably, it is preferred to appropriately eject the ink outside the image region to supply fresh ink to the head, thereby maintaining the physical properties of ink within the proper ranges as described in JP-A-11-157102. In spite of these procedures, air bubbles may enter the head or may generate in the head in some cases. In such a case, the ink is forcibly aspirated from outside the head to dispose the ink having changed in physical properties together with air bubbles as described in JP-A-11-334092. When ink ejection is suspended for a long time, the nozzle surface can be protected by covering with a cap as described in JP-A-11-138830. Despite of these measures, the nozzle can not eject the ink in some cases. Image formation with nozzles a part of which does not eject the ink courses a problem, for example, occurrence of unevenness in the image. In order to avoid such a problem, it is effective to detect an ink ejection failure and to take a necessary measure as described in JP-A-2000-343686.

### (Ejection)

In the ejection of ink, it is preferred to maintain the ink temperature constant with the prescribed precision in order to keep the ink viscosity constant. To achieve this, it is preferred to have an ink temperature monitoring means, an ink heating means and a control means for controlling the heating in response to the ink temperature monitored. It is also preferred to have a control means for controlling energy applied to the means for ejecting the ink in accordance with the ink temperature.

To conduct impact of ink droplets in superposition wherein a head unit is mechanically moved while a medium is moved intermittently in synchronization with the movement of the head unit in the direction perpendicular to the head unit moving direction as described in JP-A-6-115099 is effective for hardly visualizing unevenness resulting from insufficient precision of the intermittent movement of the medium (recording medium), whereby the high image quality can be realized. In the system, the relation among the moving speed of the head, the amount of movement of the medium and the number of the nozzles is appropriately determined so that the relation between the image quality and recording speed can be preferably established. The similar effects can be obtained when the recording head is fixed, a medium is mechanically reciprocated in the prescribed direction and at the same time intermittently moved in a direction perpendicular to the direction of reciprocation.

### (System parameter)

In the formation of image, the diameter of an ink droplet impacted on the ink-receptive layer is preferably between 5 and 500 µm, and thus the diameter of the ink droplet as it is ejected is preferably from 5 to 200 µm and the nozzle diameter is preferably from 5 to 200 µm. Particularly, in the formation of a printing plate, the volume of an ink droplet ejected is preferably 20 pl or less, particularly preferably 10 pl or less.

In order to from an image, the number of pixels per inch is preferably from 50 to 4,000 dpi, and thus the nozzle density of head is preferably from 10 to 4,000 dpi. Even when the nozzle density is low, it is possible to realize the impact of droplets in high density on a medium with a head of large nozzle interval by tilting the head against the moving direction of medium or by arranging plural head units out of alignment with each other. Further, the image recording of high density can be realized by moving the medium by the predetermined amount every time the head moves at a low nozzle pitch according to the reciprocation of head or medium as described above to impact the ink droplets on different positions.

With respect to the distance between the medium and the head, when it is too large, the ink droplet flight path is disturbed by air flow accompanying the movement of head or media, resulting in reduction of position accuracy of ink droplet impacted. When the distance is too small, on the other hand, there is a fear that the head and the medium come into contact due to the surface unevenness of the medium or vibration based on the carrier mechanism. Accordingly, the distance is preferably maintained between about 0.5 to about 2 mm.

### [Polymerization of ink by exposure]

A light source which is preferably used in the exposure of the ink includes an ordinarily employed light source, for example, a mercury lamp or a metal halide lamp and a light source, for example, a light-emitting diode, a semiconductor laser or a fluorescent lamp. Also, a light source or an electromagnetic wave advancing the polymerization reaction of the ink, for example, a hot-cathode tube, a cold-cathode tube, an electron beam or X-ray can be used. In the case of using a mercury lamp or a metal halide lamp, it is preferred to use the lamp having power of 10 to 3000 W/cm with illuminance of 1 to 300 W/cm² on the surface of a recording medium. The exposure energy is preferably from 0.1 to 1,000 mJ/cm². The exposure apparatus using, for example, a high-pressure discharge mercury lamp or a metal halide lamp is preferably equipped with an exhaust unit because the discharge is accompanied by the generation of ozone. The exhaust unit is preferably installed such that ink mist produced with the ink ejection may also be collected. In the case of curing with radical polymerization, since the polymerization is inhibited by the presence of oxygen, the exposure is preferably performed under condition of low oxygen concentration, specifically, in a nitrogen gas atmosphere or the like so that the curing can be performed with low energy. When the ink ejection nozzle is irradiated with energy for curing, for example, light, ink mist adhered to the nozzle surface may cure to interfere with the ink ejection. Hence, it is recommended to take a measure, for example, light shielding, to minimize irradiation of the nozzle. Specifically, it is preferred that a partition for preventing a nozzle plate from being irradiated is provided or a means for limiting the incident angle to the medium to reduce the stray light is provided.

In the case of conducting the polymerization with heat, for example, a panel heater or an infrared lamp can be used.

### [Gumming treatment]

The resulting lithographic printing plate having an image formed thereon may be subjected to a gumming treatment using a gumming solution containing as the main components, for example, gum arabic or a starch derivative and a surfactant before conducting printing. Preferable examples of the gumming solution include those described in JP-B-62-16834, JP-B-62-25118, JP-B-63-52600, JP-A-62-7595, JP-A-62-11693, JP-A-62-83194. It is preferred that the ink-receptive layer of the non-image area is dissolved to remove with the gumming solution in the gumming treatment. The lithographic printing plate thus obtained is mounted on a lithographic printing machine to conduct printing in a conventional manner. According to the invention, the printing plate can be used for printing without performing the gumming treatment.

### [Dampening water]

With respect to the dampening water (fountain solution) at printing, dampening water for use in printing using a conventional lithographic printing machine and conventional printing ink is employed. As the dampening water, in general, Dahlgren dampening system using as the dampening water, an aqueous solution containing from about 20 to about 25% of isopropyl alcohol is proposed and has widely spread. However, as well as having the inherent unpleasant smell, isopropyl alcohol is problematical in view of toxicity and is regulated as a second-class organic solvent in Ordinance on Prevention of Organic Solvent Poisoning (Organic Solvent Ordinance). Therefore, dampening water to which a technique of substitution for isopropyl alcohol is introduced and dampening water in which a nonvolatile or high-boiling compound is used in place of isopropyl alcohol have been developed. For example, a dampening water composition containing a specific alkylene oxide type nonionic surfactant and a dampening water composition containing an ethylene oxide and propylene oxide adduct of an alkylenediamine can be used.

### EXAMPLES

The present invention will be described in more detail with reference to the following examples, but the invention should not be construed as being limited thereto.

### EXAMPLE 1

### 1. Preparation of lithographic printing plate precursor

### (1) Preparation of support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolyte used was a 1% by weight aqueous nitric acid solution (containing 0.5% by weight of aluminum ion) and the electrolyte temperature was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolyte, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying. The plate was subjected to an anodizing treatment using as an electrolyte, a 15% by weight aqueous sulfuric acid solution (containing 0.5% by weight of aluminum ion) at a current density of 15 A/dm² to form a direct current anodized film of 2.5 g/m², washed with water and dried.

The plate was immersed in a solution heated at 75°C having pH of 3.7 and containing 0.1% by weight of sodium fluorozirconate and 1% by weight of sodium dihydrogen phosphate for 10 seconds to conduct a pore-sealing treatment. Then, the plate was treated with a 2.5% by weight sodium silicate at 30°C for 10 seconds. The center line average roughness (Ra) of the substrate was measured using a stylus having a diameter of 2 µm and it was found to be 0.51 µm.

Undercoat solution (1) shown below was coated on the substrate described above so as to have a dry coating amount of 10 mg/m² to prepare a support for using in the experiments described below.

### Undercoat solution (1)

| | |
|---|---|
| Undercoat compound (1) shown below | 0.017 g |
| Methanol | 9.00 g |
| Water | 1.00 g |

### Undercoat compound (1):

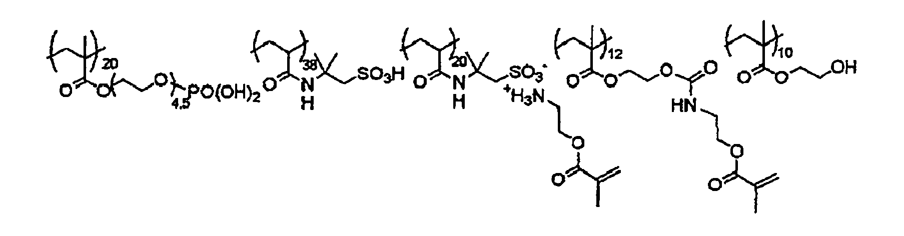

### (2) Formation of ink-receptive layer

Coating solution (1) for ink-receptive layer having the composition shown below was coated on the above-described support having the undercoat layer by a bar and dried in an oven at 100°C for 60 seconds to form an ink-receptive layer having a dry coating amount of 1.5 g/m².

Coating solution (1) for ink-receptive layer was prepared by mixing Solution (1) shown below with Microcapsule solution (1) shown below just before the coating, followed by stirring.

### Solution (1)

| | |
|---|---|
| Hydrophilic resin (polyacrylamide) | 0.3 g |
| Organic fluorine-based compound (F-12) shown below | 0.3 g |
| CF₃-(CF₂)₆-CH₂CH₂-S-CH₂CH₂-COOLi | 0.2 g |
| Surfactant (Megafac F-176, produced by Dainippon Ink & Chemicals, Inc.) | 0.05 g |
| | |
| Methyl ethyl ketone | 1.0 g |
| 1-Methoxy-2-propanol | 8.0 g |

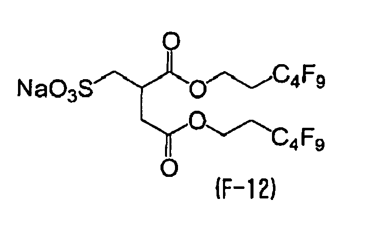

### Microcapsule solution (1)

| | |
|---|---|
| Microcapsule (1) prepared as shown below | 3.0 g |
| Water | 2.0 g |

### (Preparation of Microcapsule (1))

An oil phase component was prepared by dissolving 11 g of adduct of trimethylol propane and xylene diisocyanate (Takenate D-110N, produced by Mitsui Takeda Chemical Co., Ltd.), 4 g of pentaerythritol triacrylate (SR444, produced by Nippon Kayaku Co., Ltd.) and 0.1 g of Pionin A-41C (produced by Takemoto Oil & Fat Co., Ltd.) as a dispersing agent in 17 g of ethyl acetate. As an aqueous phase component, 40 g of a 4% by weight aqueous PVA-205 solution was prepared. The oil phase component and the aqueous phase component were mixed and emulsified using a homogenizer at 12,000 rpm for 10 minutes. The resulting emulsion was added to 25 g of distilled water and stirred at a room temperature for 30 minutes and then at 40°C for 3 hours. The thus obtained microcapsule liquid was diluted using distilled water so as to have the solid concentration of 15% by weight. The average particle size of the microcapsule was 0.2 µm.

### <Preparation of ink>

Solvent type ink (inkjet ink) having the composition shown below was prepared.

| | |
|---|---|
| Oleophilic polymer : Copolymer of butyl acrylate, 2-hydroxyethyl methacrylate and acrylic acid (60/30/10 in molar ratio) (weight average molecular weight: 100,000) | 9 g |
| Dye: Ethyl Violet | 1 g |
| Solvent: Propylene glycol monomethyl ether acetate | 50 g |
| Solvent: Ethyl lactate | 40 g |

### <Inkjet recording>

The solvent type ink was ejected on the lithographic printing plate precursor by an inkjet recording method to prepare a lithographic printing plate for Example 1. A shear mode piezo inkjet head was used as the inkjet head at the drawing.

### <Printing evaluation>

The lithographic printing plate was mounted without performing a gumming treatment on a printing machine (Lithrone, produced by Komori Corp.) and printing was conducted using dampening water (IF102, produced by Fuji Film Co., Ltd.) and DIC-GEOS (N) Black Ink (produced by Dainippon Ink & Chemicals, Inc.). Opening in the solid portion and the cross point of fine lines were visually evaluated using a loupe. As a result, the opening in the solid portion and spread at the cross point of fine lines were not observed. The printing durability was evaluated from a number of printing papers wherein the ink density of solid portion decreased by 0.1 compared with that of the initiation of printing. As a result, the printing durability was 1.5 x 10⁴ sheets. Also, stain was not observed in the non-image area.

### COMPARATIVE EXAMPLE 1

The same procedures as in Example 1 were repeated except that only Solution (1) was coated so as to have a dry coating amount of 1.5 g/m² thereby forming an ink-receptive layer. As a result of the evaluation in the same manner as in Example 1, openings in the solid portion were observed and spread at the cross point of fine lines was observed. The printing durability was 0.5 x 10⁴ sheets. Stain was not observed in the non-image area.

### EXAMPLE 2

The inkjet recording was conducted on the lithographic printing plate precursor as described in Example 1 in the following manner. Specifically, while conducting the inkjet recording using the ink having the composition shown in Table 2 below, the droplet impacted on the ink-receptive layer was blown with warm air of 35°C to volatilize the solvent and after 1 to 60 seconds, the image area after the completion of the solvent volatilization process was exposed by two lamps of 150 W (Super high pressure mercury lamp SHP, produced by Phoenix Electric Co., Ltd.) from distance of 10 cm at area of 5 cm² per second to cure the ink. The surface temperature at the exposure was 35°C. The same procedures as in Example 1 were conducted except the above processes.

As a result of the evaluations in the same manner as in Example 1, the opening in the solid portion and spread at the cross point of fine lines were not observed. The printing durability was 3.5 x 10⁴ sheets. Also, stain was not observed in the non-image area.

| Component | Kind | Amount |
|---|---|---|
| Dye | Oil Blue N | 0.5 g |
| Photopolymeriza tion initiator | Diphenyl(2,4,6-trimethylbenzoyl)phos phine oxide | 5 g |
| Sensitizer | 2,4-Diethylthioxanthone | 5 g |
| Polymerizable monomer | Dipropylene glycol diacrylate | 20 g |
| Polymerizable monomer | Dipentaerythritol hexaacrylate | 20 g |
| Oleophilic polymer | Copolymer of allyl methacrylate, benzyl acrylate and methacrylic acid (50/25/25 in molar ratio) (weight average molecular weight: 120,000) | 30 g |
| Organic solvent | Diethylene glycol diethyl ether (boiling point: 188°C) | 40 g |
| Organic solvent | Ethyl lactate (boiling point: 151 to 155°C) | 40 g |

### COMPARATIVE EXAMPLE 2

The same procedures as in Example 2 were repeated except that only Solution (1) was coated so as to have a dry coating amount of 1.5 g/m² thereby forming an ink-receptive layer. As a result of the evaluation in the same manner as in Example 1, openings in the solid portion were observed and spread at the cross point of fine lines was observed. The printing durability was 1. 0 x 10⁴ sheets. Stain was not observed in the non-image area.

### EXAMPLE 3

The same procedures as in Example 2 were conducted but after the exposure, a gumming treatment was carried out and then the printing was conducted. As a gumming solution for the gumming treatment, a solution prepared by diluting GU-7 (produced by Fuji Film Co., Ltd.) with water at a ratio of 1:1 was used.

As a result of the evaluations in the same manner as in Example 1, the opening in the solid portion and spread at the cross point of fine lines were not observed. The printing durability was 3.5 x 10⁴ sheets. Also, stain was not observed in the non-image area.

### EXAMPLE 4

The same procedures as in Example 2 were repeated except for changing Solution (1) to Solution (2) having the composition shown below.

### Solution (2)

| | |
|---|---|
| Hydrophilic resin (polymethacrylic acid) | 0.2 g |
| Polymerizable compound (Aronix M215, produced by Toagosei Co., Ltd.) | 0.2 g |
| Organic fluorine-based compound (F-12) shown above | 0.2 g |
| CF₃-(CF_{Z})₆-CH₂CH₂-S-CH₂CH₂-COOLi | 0.2 g |
| Surfactant (Megafac F-176, produced by Dainippon Ink & Chemicals, Inc.) | 0.05 g |
| Methyl ethyl ketone | 1.0 g |
| 1-Methoxy-2-propanol | 8.0 g |

As a result of the evaluations in the same manner as in Example 1, the opening in the solid portion was not observed. The printing durability was 4.0 x 10⁴ sheets. Also, stain was not observed in the non-image area.

### EXAMPLE 5

The same procedures as in Example 2 were repeated except for changing Solution (1) to Solution (3) having the composition shown below and changing Microcapsule (1) to Microcapsule (2) having the composition shown below.

### Solution (3)

| | |
|---|---|
| Hydrophilic resin (polyvinyl alcohol) | 0.3 g |
| Polymerization initiator | 0.1 g |
| (diphenyl(2,4,6-trimethylbenzoyl)phosphine oxide) Sensitizer (2,4-diethylthioxanthone) | 0.1 g |
| Organic fluorine-based compound (F-12) shown above | 0.3 g |
| CF₃- (CF₂)₇-CH₂CH₂-S-CH₂CH₂-COOLi | 0.2 g |
| Surfactant (Megafac F-176, produced by Dainippon Ink & Chemicals, Inc.) | 0.05 g |
| Methyl ethyl ketone | 1.0 g |
| 1-Methoxy-2-propanol | 8.0 g |

### (Preparation of Microcapsule (2))

An oil phase component was prepared by dissolving 11 g of adduct of 2,2-bis(hydroxymethyl)propionic acid (produced by Aldrich) and xylene diisocyanate (Takenate D-110N, produced by Mitsui Takeda Chemical Co., Ltd.), 4 g of pentaerythritol triacrylate (SR444, produced by Nippon Kayaku Co., Ltd.) and 0.1 g of Pionin A-41C (produced by Takemoto Oil & Fat Co., Ltd.) in 17 g of ethyl acetate. As an aqueous phase component, 40 g of a 4% by weight aqueous PVA-205 solution was prepared. The oil phase component and the aqueous phase component were mixed and emulsified using a homogenizer at 12,000 rpm for 10 minutes. The resulting emulsion was added to 25 g of distilled water and stirred at a room temperature for 30 minutes and then at 40°C for 3 hours. The thus obtained microcapsule liquid was diluted using distilled water so as to have the solid concentration of 15% by weight. The average particle size of the microcapsule was 0.2 µm.

As a result of the evaluations in the same manner as in Example 1, the opening in the solid portion and spread at the cross point of fine lines were not observed. The printing durability was 3.5 x 10⁴ sheets. Also, stain was not observed in the non-image area.

### EXAMPLE 6

The inkjet recording was conducted on the lithographic printing plate precursor as described in Example 1 in the following manner. Specifically, the inkjet recording was conducted using the ink having the composition shown in Table 3 below, and after the inkjet recording, the surface of the lithographic printing plate precursor was heated by an infrared lamp at the surface temperature of 150°C for 3 minutes. The same procedures as in Example 1 were conducted except the above process.

| Component | Kind | Amount |
|---|---|---|
| Dye | Oil Blue N | 0.5 g |
| Thermal polymerization initiator | Azobisisobutyronitrile | 10 g |
| Polymerizable monomer | Dipropylene glycol diacrylate | 20 g |
| Polymerizable monomer | Dipentaerythritol hexaacrylate | 20 g |
| Oleophilic polymer | Copolymer of allyl methacrylate, benzyl acrylate and methacrylic acid (50/25/25 in molar ratio) (weight average molecular weight: 120,000) | 30 g |
| Organic solvent | Diethylene glycol diethyl ether (boiling point: 188°C) | 40 g |
| Organic solvent | Ethyl lactate (boiling point: 151 to 155°C) | 40 g |

As a result of the evaluations in the same manner as in Example 1, the opening in the solid portion and spread at the cross point of fine lines were not observed. The printing durability was 3.0 x 10⁴ sheets. Also, stain was not observed in the non-image area.

This application is based on Japanese Patent application JP 2007-072239, filed March 20, 2007, the entire content of which is hereby incorporated by reference, the same as if fully set forth herein.

Although the invention has been described above in relation to preferred embodiments and modifications thereof, it will be understood by those skilled in the art that other variations and modifications can be effected in these preferred embodiments without departing from the scope and spirit of the invention.

## Claims

1. A lithographic printing plate precursor comprising a support and an ink-receptive layer comprising a microcapsule.

2. The lithographic printing plate precursor as claimed in Claim 1, wherein the ink-receptive layer further comprises an organic fluorine-based compound.

3. The lithographic printing plate precursor as claimed in Claim 1, wherein the microcapsule has a crosslinked structure.

4. The lithographic printing plate precursor as claimed in any one of Claims 1 to 3, wherein the microcapsule is a hollow microcapsule.

5. A method for preparing a lithographic printing plate with a lithographic printing plate precursor comprising a support and an ink-receptive layer comprising a microcapsule, the method comprising: forming an image on the ink-receptive layer with inkjet ink by an inkjet recording system.

6. The method for preparing a lithographic printing plate as claimed in Claim 5, wherein the inkjet ink comprises an oleophilic polymer.

7. The method for preparing a lithographic printing plate as claimed in Claim 5 or 6, wherein the ink-receptive layer further comprises a polymerizable compound and the inkjet ink comprises a polymerization initiator.

8. The method for preparing a lithographic printing plate as claimed in Claim 5 or 6, wherein the ink-receptive layer further comprises a polymerization initiator and the inkjet ink comprises a polymerizable compound.

9. The method for preparing a lithographic printing plate as claimed in any one of Claims 5 to 8, further comprising: removing a non-image area of the ink-receptive layer on which the image has not been formed with the inkjet ink, with a gum solution or dampening water.
